# EUROPEAN PATENT APPLICATION

(11) **EP 3 832 670 A1**
(43) Date of publication of application: **09.06.2021**
(21) Application number: 18927630.6
(22) Date of filing: 30.11.2018
(51) Int. Cl.: H01B 7/00, H01B 7/02, H01B 7/06, H01B 13/00, H01B 13/008, H05K 1/02

(54) **WIRE FOR USE IN EXTENDABLE ELECTRONIC DEVICE, EXTENDABLE ELECTRONIC DEVICE AND PREPARATION METHOD**

(30) Priority: 27.07.2018 CN 201810848155
(71) Applicant: Institute of Flexible Electronics Technology of Thu, Zhejiang, Jiaxing, Zhejiang 314006 (CN); Tsinghua University, Beijing 100084 (CN)
(72) Inventor: FENG, Xue, Jiaxing, Zhejiang 314006 (CN); FU, Haoran, Jiaxing, Zhejiang 314006 (CN); JIANG, Ye, Jiaxing, Zhejiang 314006 (CN)
(74) Representative: Papa, Elisabetta
(86) International application number: PCT/CN2018/118525
(87) International publication number: WO 2020/019617

(57) **Abstract**

A wire (1) for use in an extendable electronic device, an extendable electronic device and a preparation method, the wire (1) being provided with hollow regions (1a, 1b, 1e, 3a, 3b, 3c, 4a, 4b, 4c, 4d, 4e) allowing extension and deformation of the wire (1). Functional elements (2a, 2b) in the electronic device are connected by means of a thin film in combination with the hollow regions (1a, 1b, 1e, 3a, 3b, 3c, 4a, 4b, 4c, 4d, 4e), ensuring the functional density while increasing the extensibility of the device, and achieving the requirements for the extensibility and portability of the flexible electronic device.

## Description

### CROSS-REFERENCE TO RELATED APPLICATION

This application claims priority to and benefits of Chinese Patent Application Serial No. 201810848155.9, filed with the National Intellectual Property Administration of P. R. China on July 30, 2018, and titled "WIRE FOR USE IN EXTENDABLE ELECTRONIC DEVICE, EXTENDABLE ELECTRONIC DEVICE AND PREPARATION METHOD", the entire content of which is incorporated herein by reference.

### FIELD

The present disclosure relates to the field of flexible electronic technology, and more particularly to a wire for use in an extendable electronic device, an extendable electronic device and a preparation method.

### BACKGROUND

Most of the current flexible electronic products, such as electrocardiograph (ECG) patches, temperature patches, *etc.,* can only achieve flexibility but have very limited extensibility, while the human skin has strong extensibility. When these devices are attached on the surface of a human body, such as elbow, wrist, thigh, *etc.,* the device will debond due to the violent contraction and stretching of the skin.

Some other flexible electronic products, such as sport wristbands, although have greater extensibility (e.g., 10% to 20%), since the extensibility of the devices is mainly undertaken by the wire in the design, the integration degree of functional elements is sacrificed. In other words, the number of functional elements in the unit area is small. If the similar extendable design method is applied to other flexible electronic devices with more complex functions, the volume of the device will be greatly increased and the portability of the device will be reduced.

In order to ensure that the flexible electronic devices still have complete functionality in a complex external environment, it is necessary to solve the contradiction between the poor deformability of the semiconductor materials and the greater extensibility and flexibility requirements of the overall device. For this problem, many research institutions have improved the deformability of semiconductor devices by the development of new materials, such as organic semiconductor materials and polymers doped with single-walled carbon nanotubes. However, these new materials are not as good as traditional inorganic materials in electrical properties, for example, the conductivity of a general conductive polymer (about 100 S/cm) is much lower than that of copper (5.96 × 10⁵ S/cm). On the other hand, some researchers focus on the structural design of the flexible electronic devices. They integrate traditional inorganic semiconductor materials with a flexible carrying substrate and optimize the design method of the substrate and the wire, so that the electronic devices can not only meet the deformation requirements, but also hold good electrical properties.

At present, in the research on inorganic flexible electronic devices, there are mainly three solutions to achieve the device extensibility, which are: wave structure method, straight wire island-bridge structure method and serpentine wire island-bridge structure method.

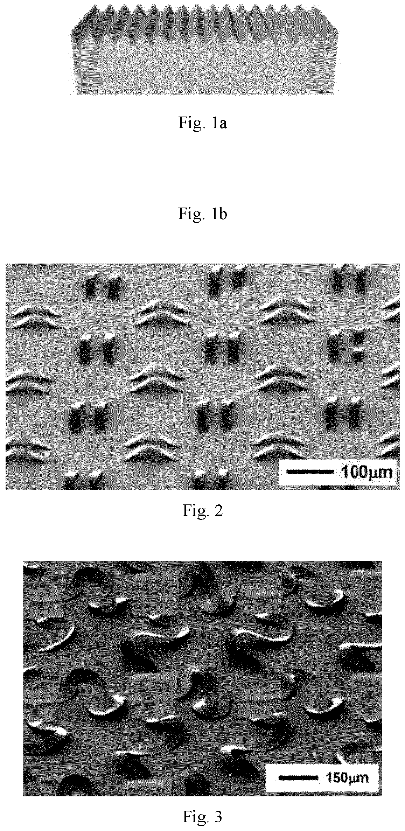

The wave structure method is achieved by introducing buckling to a film-substrate system, as shown in Fig. 1a and Fig. 1b. A ribbon-shaped film (i.e. a functional element) with high rigidity is bonded to a pre-stretched flexible substrate, and after the substrate is released, the film deforms in a wave-like shape together with the substrate due to buckling, such that the device can withstand greater tensile strain. The extendable electronic devices designed and prepared by this method include skin-like sensors, flexible displays and so on.

As shown in Fig. 2, in the straight wire island-bridge structure method, the functional elements (islands) are bonded to the pre-stretched substrate by a chemical method, in which the elements are connected by wires (bridges), and the wires are not bonded with the substrate. After releasing the pre-strain, the wire arches due to out-of-plane buckling to improve the extensibility of the flexible electronic device. The extendable electronic devices designed and prepared by this method include electronic eye cameras that mimic human eyes, flexible LED displays and the like.

As shown in Fig. 3, in the serpentine wire island-bridge structure method, adjacent functional components are connected by the serpentine wire, and then the island-bridge structures are printed on a substrate without pre-stretch. When the device is stretched, the wire will bend and twist out of plane (i.e. out-of-plane buckling), thus reducing the strain energy of the wire. The extendable electronic devices designed and prepared by this method include multifunctional skin electronics, extendable lithium ion batteries and the like.

The above-mentioned three design methods all have certain limitations. Among them, the wave structure method can only achieve a small extension rate (about 10%). Although the straight wire island-bridge structure method and serpentine wire island-bridge structure method can achieve a higher extension rate (about 40% and about 100%, respectively), due to the introduction of the wires, a large space is required between the functional elements to accommodate the long wires, and thus the mechanical properties (e.g., the extension rate) and electrical properties (e.g., resistance, functional density, *etc*.) of the device become contradictory indicators, and at the same time, the integration degree of the functional components is also affected. The contradiction between the extension rate and the functional density greatly limits the microminiaturization, commercialization and applicable range of the extendable electronic devices.

### SUMMARY

In view of the problem that the extension rate and the functional density are difficult to compatible, it is necessary to provide a wire for use in an extendable electronic device, in which functional elements of the electronic device are connected by a film in combination with hollow regions, which not only increases the extensibility of the device, but also secures the functional density of the device (i.e., a ratio of a total area of the functional elements and the wires to an area of the device), thereby meeting requirements of the flexible electronic device on both the extensibility and the portability.

Embodiments of the present disclosure provide a wire for use in an extendable electronic device, and the wire is provided with a hollow region allowing extension and deformation of the wire.

The present disclosure also provides several embodiments, which merely are supplements or optimizations of the above-mentioned general scheme, but shall not be construed to limit the present disclosure. Without technical or logical contradictions, each embodiment can be individually combined with the above general scheme, and multiple embodiments can also be combined with each other.

In one of the embodiments, the wire has a planar structure before the extendable electronic device is deformed.

In one of the embodiments, the hollow region has at least two hollow structures spaced apart from each other, and an inner edge of at least one of the hollow regions is closed.

In one of the embodiments, the hollow region has a smooth inner edge.

In one of the embodiments, the wire includes a conductive layer and an insulating layer wrapping around the conductive layer.

In one of the embodiments, the hollow region is stripe-shaped.

In one of the embodiments, a width of the hollow region is in a range of 0.1 µm to 10 µm.

In one of the embodiments, the hollow region extends along a straight line or a curve.

In one of the embodiments, different hollow regions extend in an identical way or in different ways.

In one of the embodiments, at least two of the hollow regions are substantially half-enclosed with each other.

In one of the embodiments, one of the hollow regions is arranged adjacent to another hollow region, and two adjacent hollow regions are substantially half-enclosed with each other.

In one of the embodiments, at least one of the hollow regions extends to and is open at an edge of the wire.

In one of the embodiments, projections in any direction of the two hollow regions substantially half-enclosed with each other have an overlapping area.

In one of the embodiments, any division line between two hollow regions substantially half-enclosed with each other is a curve, that is, there is no division line extending in a straight direction.

In one of the embodiments, the wire has at least one deformable extension direction, and electrode connection portions for connecting with a functional element are provided at both ends of the wire in the extension direction and exposed outside the insulating layer.

In one of the embodiments, the wire and the electrode connection portions are integral.

In one of the embodiments, a plurality of groups of the hollow regions are arranged in an extension direction to divide the wire into a plurality of ring structures arranged in sequence, and adjacent ones of the ring structures are connected via a transition portion.

In one of the embodiments, the hollow region is stripe-shaped and extends in a direction perpendicular or oblique to the extension direction, and the hollow region between the adjacent ones of the ring structures extends to and opens at a respective edge of the wire.

In one of the embodiment, one or more groups of the hollow regions are arranged in an extension direction, the same group of the hollow regions includes two units in the extension direction, one or more of the hollow regions in the same unit are arranged in a direction perpendicular or oblique to the extension direction, and adjacent ones of the hollow regions in the same group but in different units are substantially half-enclosed with each other.

In one of the embodiment, the hollow region is formed by coating, etching or cutting.

Embodiments of the present disclosure provide a method of producing a wire for use in an extendable electronic device. The method includes forming a conductive layer and processing a respective region of the conductive layer to obtain a hollow region.

In one of the embodiments, the wire is a wire according to present disclosure.

Embodiments of the present disclosure provide a method of producing a wire for use in an extendable electronic device. The method includes: preparing a first insulating layer; forming a conductive layer on the first insulating layer, and processing a respective region of the conductive layer to obtain a hollow region; and preparing a second insulating layer, and wrapping the conductive layer by the first insulating layer and the second insulating layer.

In one of the embodiments, the wire is a wire according to present disclosure.

Embodiments of the present disclosure provide an extendable electronic device. The extendable electronic device includes a substrate and an encapsulation layer, in which a plurality of functional elements are arranged between the substrate and the encapsulation layer, and at least two of the functional elements are electrically connected with each other via the above described wire.

In one of the embodiments, a wire layer is bonded and fixed on the substrate, a part of the wire layer is a complete region where the functional element is located, and another part of the wire layer is provided with the hollow region and is taken as the wire.

In one of the embodiments, a post is provided on the substrate, the complete region is disposed on the post, and a void space for accommodating the deformed wire is provided between the substrate and the encapsulation layer.

In one of the embodiments, the posts are spaced from each other.

Embodiments of the present disclosure provide a method of producing an extendable electronic device. The method includes providing a substrate and forming at least one wire layer and at least one functional element layer on the substrate, followed by encapsulating; in which the wire layer and the functional element layer are formed on the substrate layer by layer, or the functional element layer is formed on the wire layer in advance.

The wire and extendable electronic device of the present disclosure solve the contradiction between the extensibility and functional density in flexible electronic devices, such that the devices have a more compact structure, a smaller volume and wider applicable range.

### BRIEF DESCRIPTION OF THE DRAWINGS

Fig. 1a is a schematic diagram of a wave structure;
Fig. 1b is a schematic scanning electron micrograph of a wave structure of a single crystal silicon strip formed on a PDMS (polydimethylsiloxane) substrate;
Fig. 2 is a schematic scanning electron micrograph of an island-bridge structure of a silicon nano-film on a PDMS substrate;
Fig. 3 is a schematic scanning electron micrograph of a serpentine wire island-bridge structure;
Fig. 4a is a schematic diagram of a wire in example 1;
Fig. 4b is a schematic diagram of the wire shown in Fig. 4a after stretched;
Fig. 5a is a schematic diagram of existing serpentine wires;
Fig. 5b is a schematic diagram of the wire shown in Fig. 5a after stretched;
Fig. 6 is a schematic diagram of a wire in example 2;
Fig. 7 is a schematic diagram of a wire in example 3;
Fig. 8 is a schematic diagram of a wire in example 4;
Fig. 9 is a schematic diagram of a wire in example 5;
Fig. 10a is a schematic diagram of an extendable electronic device in example 6;
Fig. 10b is a schematic diagram of a substrate of the extendable electronic device in example 6 with changed distribution of posts;
Fig. 11 is a schematic diagram of a substrate with a post in example 7;
Fig. 12 is a schematic diagram of a substrate with a post in example 8; and
Fig. 13 is a schematic diagram of an LC circuit in example 8.

### DETAILED DESCRIPTION

### Example 1

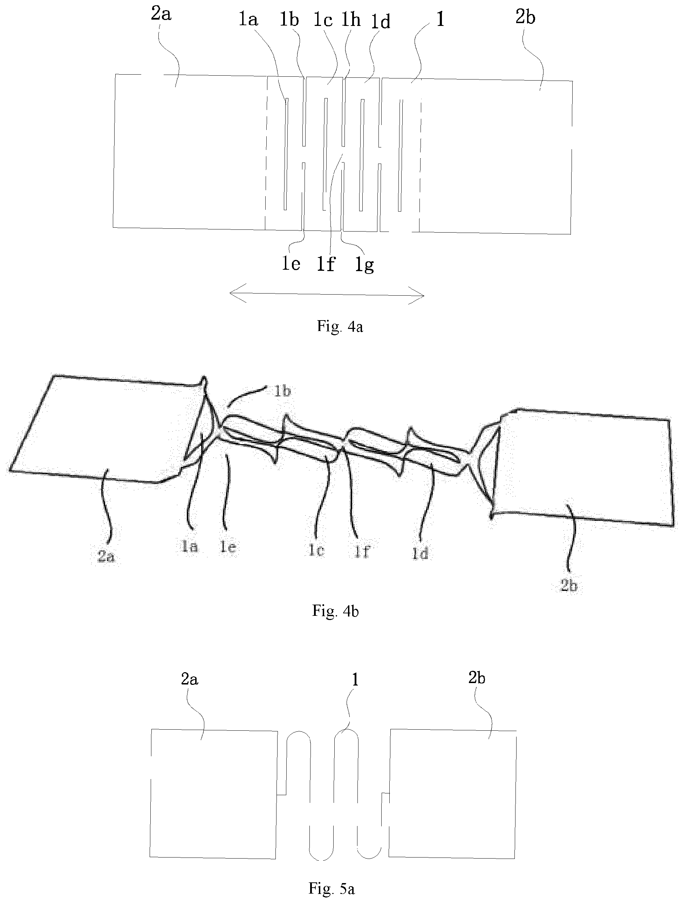

As shown in Fig. 4a, in this example, a wire for use in an extendable electronic device is provided, and the wire 1 is provided with hollow regions, e.g. a hollow region 1a and a hollow region 1b in Fig. 4a, which allow the extension and deformation of the wire 1.

In Fig. 4a, the wire 1 is located at a central region, functional elements 2a and 2b are located at two side regions, respectively, and the functional elements 2a and 2b are electrically connected by the wire 1.

The wire 1 is applicable to an extendable electronic device. When the extendable electronic device is deformed, the distance between the functional element 2a and the functional element 2b will increase, the wire 1 will extend and deform due to the presence of the hollow region, and the hollow region will deform accordingly to adapt to the overall elongated wire 1.

Although some construction characteristics of the hollow region are not substantially changed after the extension and deformation of the wire 1, the specific shape of the hollow region will slightly change. Therefore, without special instructions in the present disclosure, the shape and the distribution of the hollow regions should be understood as the state before the wire is extended and deformed.

As shown in Fig. 4b, compared with Fig. 4a, after the extendable electronic device is deformed, two ends of the wire 1 connected with the functional element 2a and the functional element 2b are far away from each other, and the wire 1 is overall elongated.

In a preferred embodiment, the wire 1 has a planar structure before the extendable electronic device is deformed.

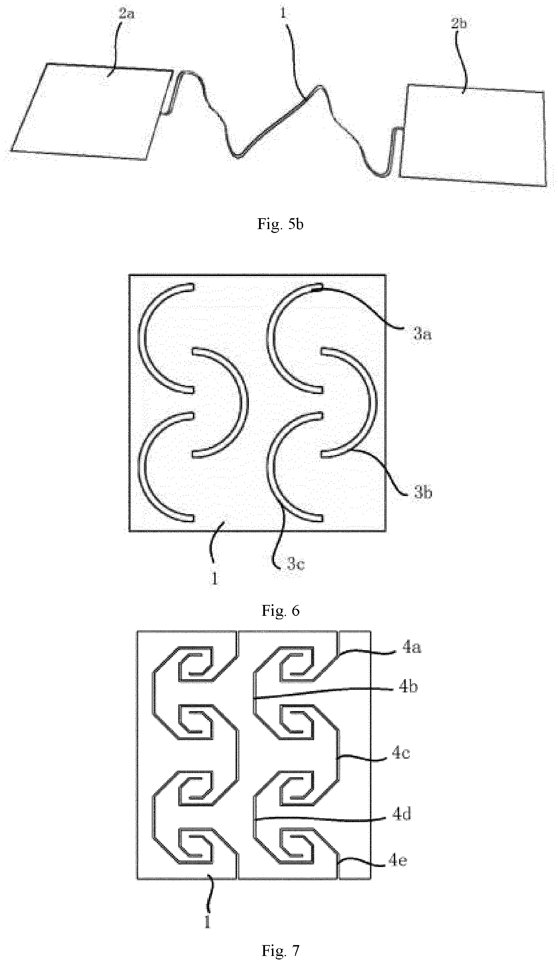

The term "planar" used herein can be understood as that the wire 1 has a planar structure as a whole, while the existing serpentine wires shown in Fig. 5a and Fig. 5b can basically be regarded as circuitous linear structures, and the functional element 2a and functional element 2b are connected via the wire 1.

The wire 1 of this example has a planar structure before the extendable electronic device is deformed, such that the wire 1 in this example has a significantly higher extension rate than that of the existing wires while ensuring a certain circuit performance. Besides that, the term "planar" may be further understood as that the planar structure is basically a plane, and the wire 1 has a film structure as a whole, which further improves the space utilization rate and guarantees the functional density.

In a preferred embodiment, in order to ensure and improve the extension rate, there are at least two hollow regions spaced apart from each other, and an inner edge of at least one of the hollow regions is closed.

The combination of multiple hollow regions is able to form relatively complex patterns, such as paper-cut or garland patterns, which can increase the extension rate of the wire 1 while ensuring the connection strength of the wire 1. When the inner edge of at least one of the hollow regions is closed, though deformation occurs at this part, a local parallel structure can be ensured to stably conduct the circuit and avoid disconnection caused by partial fracture.

In a preferred embodiment, the hollow region has a smooth inner edge, which can avoid local stress concentration. In a further preferred embodiment, all of the hollow regions have smooth inner edges.

As to the wire 1 per se, it includes a conductive layer and an insulating layer wrapped around the conductive layer. Of course, only the conductive layer is electrically connected to the functional element 2a and the functional element 2b, and the manner of the layer structure also determines that the wire has a film structure as a whole.

In a preferred embodiment, the hollow region is stripe-shaped, which not only is easy to process, but also can ensure the usable area of the wire 1, and the long and narrow hollow region also allows a large amount of deformation. In a further preferred embodiment, all of the hollow regions are stripe-shaped.

When the extendable electronic device is stretched, the hollow structure of the wire 1 will gradually deform and expand to enable the wire 1 to form an interconnected ribbon-shaped film. Because the in-plane bending of the ribbon-shaped film will accumulate a large amount of strain energy, out-of-plane buckling will occur to the ribbon-shaped film to reduce the strain energy. In this process, the film bears almost all the strain of the electronic device, while the functional element 2a and the functional element 2b almost bear no strain. When the film is deformed, the expansion of the internal structure and the strain isolation from the functional elements increase the extension rate of the extendable electronic device. Further, the larger width and high space utilization of the film also increase the functional density of the extendable electronic device, which is beneficial to the large scale integration of the circuit.

By comparison through numerical simulation, when the distance between the functional elements is the same, the functional density and extension rate of the extendable electronic device using the wire of this example are greatly improved than that of an electronic device with a traditional serpentine wire design. In particular, when the arrangement of the functional elements is a 3 × 3 array, the extendable electronic device using the wire of this example has the functional density of 85% and the extension rate of 120%, while the extendable electronic device using the traditional serpentine wire has the functional density of 46% and the extension rate of 80%.

In this example, the strip-shaped hollow region extends along a straight line. In other embodiments, the strip-shaped hollow region may also extend along a curve, or along a combination of a curve and a straight line.

Different strip-shaped hollow regions may extend in an identical way or in different ways. For example, all hollow regions extend along a straight line, or all hollow regions extend along a curve, or a part of the hollow regions extend along a straight line, while another part of the hollow regions extend along a curve.

The term "curve" used herein may refer to a smooth arc, or other types of curves, or a combination of a broken line or straight line with an arc and so on, which is defined relative to a straight line only.

Each of the two ends of the wire 1 is connected to the functional element. The shortest connection between the two functional elements can be regarded as the shortest distance between the two functional elements in the extension direction that allows the deformation of the wire. Apart of the wire 1 between the two functional elements has a side (i.e. an edge) arranged along the extension direction, and it is preferred that at least one of the hollow regions extends to and is open at the edge.

In order to facilitate the connection with the functional elements, electrode connection portions for connecting with the functional elements are provided at both ends of the wire 1 in the extension direction and exposed outside the insulating layer to facilitate the conduction with the functional element. In a preferred embodiment, the wire 1 and the electrode connection portions are integral, which is convenient for integral molding and processing. The shape of the electrode connection part is not particularly limited herein, and may be matched with the shape of a connection part of the functional element.

The wire 1, i.e., the part with the hollow region, may be in an exposed state in use, or may be subjected to an insulating treatment, such as being wrapped with an insulating layer.

The part of the wire 1 subjected to the insulating treatment is not particularly limited herein, because after the wire is applied to the extendable electronic device, the overall structure of the device will be encapsulated finally, such that the wire will be insulated from the outside. In addition, when the wire is stretched, the wire will not extend in a direction perpendicular to the extension direction within a plane where the device is located, such that cross among different wires will not happen, and additional insulation treatment is not needed.

The insulating treatment can be performed in the following ways, for example, all parts of a same wire are insulated (except the part to be connected to an external circuit); or all parts of a same wire are not insulated; or some parts of a same wire are insulated, and other parts of the wire are not insulated; or one of two surfaces of a same wire facing and facing away from the substrate is insulated.

As shown in Fig. 4a and Fig. 4b, the direction illustrated by the arrow in Fig. 4a is regarded as the extension direction of the wire 1. Before the extension, each hollow region is a straight and long strip, such as the hollow region 1a and hollow region 1b in Fig. 4a.

In this example, a plurality of groups of the hollow regions are arranged in the extension direction, each group has one or two hollow regions, for example, a first group has only one hollow region 1a, and an adjacent second group has two hollow regions, one of which is the hollow region 1b, and the other of which is a hollow region 1e extending in the same direction as the hollow region 1b and spaced apart from the hollow region 1b in the direction perpendicular to the extension direction. The plurality of groups of the hollow regions divides the wire into a plurality of ring structures arranged in sequence, e.g. a ring structure 1c and a ring structure Id, and adjacent ones of the ring structures are connected via a transition portion If.

Each hollow region is stripe-shaped and extends in the direction perpendicular to the extension direction, and a hollow region Ig and a hollow region 1h between the ring structure 1c and the ring structure Id extend to and open at a respective edge of the wire.

### Example 2

In this example, on the basis of example 1, the shape of the hollow region is changed. As an example, Fig. 6 shows six hollow regions. However, it will be appreciated to those skilled in the art that the number of the hollow regions actually may be increased or decreased accordingly based on the actual area of the wire 1.

The hollow regions in Fig. 6 are divided into two groups in the extension direction of the wire 1. For example, one of the two groups includes a hollow region 3a, a hollow region 3b and a hollow region 3c, and the same is true for the other group.

The hollow region 3a, the hollow region 3b and the hollow region 3c are arranged along a direction perpendicular to the extension direction as a whole. This group may also be regarded to include two units in the extension direction, in which the hollow region 3a and the hollow region 3c are regarded as a unit, and the hollow region 3b is regarded as the other unit. The hollow region 3a and the hollow region 3c in the same unit are arranged in a direction perpendicular to the extension direction, and two adjacent hollow regions in the same group but in different units are substantially half-enclosed with each other, for example, the hollow region 3a and the hollow region 3b are half-enclosed with each other, and the hollow region 3b and the hollow region 3c are half-enclosed with each other.

Each hollow region is arranged adjacent to another hollow region, and two adjacent hollow regions are substantially half-enclosed with each other.

Projections in any direction of two hollow regions substantially half-enclosed with each other have an overlapping area, or any division line between two hollow regions substantially half-enclosed with each other is a curve, that is, there is no division line extending in a straight direction. In such a circuitous arranging manner with each other, the two hollow regions substantially half-enclosed with each other allow a greater extension rate.

For each hollow region, it may have many forms, such as any combination of arcs, spiral line, broken lines, straight lines, and curves.

### Example 3

In this example, on the basis of example 1, the shape of the hollow region is changed. As an example, Fig. 7 shows ten hollow regions. However, it will be appreciated to those skilled in the art that the number of the hollow regions may be increased or decreased accordingly based on the actual area of the wire 1.

The hollow regions in Fig. 7 are divided into two groups in the extension direction of the wire 1. For example, one of the two groups includes a hollow region 4a, a hollow region 4b, a hollow region 4c, a hollow region 4d and a hollow region 4e, and the same is true for the other group.

The shape of each group of the hollow regions is not strictly required to be the same, for example, one group of hollow regions in this example may be combined with a group of hollow regions described in example 2.

The hollow regions in the same group are arranged in a direction perpendicular to the extension direction as a whole. Each group may also be regarded to include two units in the extension direction, for example, the hollow region 4a, the hollow region 4c and the hollow region 4c are regarded as a unit, and the hollow region 4b and the hollow region 4d are regarded as the other unit. The hollow regions in the same unit are arranged in the direction perpendicular to the extension direction, and two adjacent hollow regions in the same group but in different units are substantially half-enclosed with each other, for example, the hollow region 4a and the hollow region 4b are half-enclosed with each other, and the hollow region 4b and the hollow region 4c are half-enclosed with each other.

Each hollow region is arranged adjacent to another hollow region, and two adjacent hollow regions are substantially half-enclosed with each other.

Projections in any direction of two hollow regions substantially half-enclosed with each other have an overlapping area, or any division line between two hollow regions substantially half-enclosed with each other is a curve, that is, there is no division line extending in a straight direction. In such a circuitous arranging manner with each other, the two hollow regions substantially half-enclosed with each other allow a greater extension rate.

Among these hollow regions, the hollow region 4a and the hollow region 4e adjacent to the respective sides of wire 1 extend to and open at the respective edges of the wire to improve the extension rate.

### Example 4

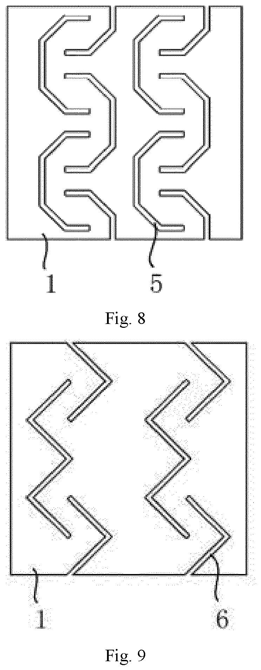

In this example, on the basis of example 1, the shape of the hollow region is changed. As an example, Fig. 8 shows ten hollow regions, one of which for example is a hollow region 5. However, it will be appreciated to those skilled in the art that the number of the hollow regions may be increased or decreased accordingly based on the actual area of the wire 1.

The hollow regions in Fig. 8 are divided into two groups along the extension direction of the wire 1. Taking one group as an example, it may also be regarded to include two units in the extension direction, and the distribution and the circuitous way of the hollow regions in the same unit may refer to the descriptions in example 3.

### Example 5

In this example, on the basis of example 1, the shape of the hollow region is changed. As an example, Fig. 9 shows six hollow regions, one of which for example is a hollow region 1. However, it will be appreciated to those skilled in the art that the number of the hollow regions may be increased or decreased accordingly based on the actual area of the wire 1.

The hollow regions in Fig. 9 are divided into two groups along the extension direction of the wire 1. Taking one group as an example, it may also be regarded to include two units in the extension direction, and the distribution and the circuitous way of the hollow regions in the same unit may refer to the descriptions in example 3.

### Example 6

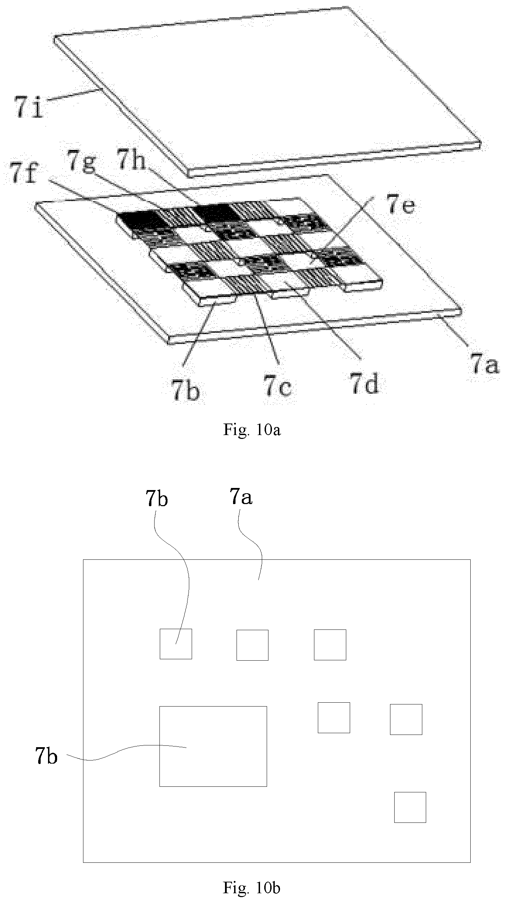

As shown in Fig. 10a, an extendable electronic device is provided. The extendable electronic device in this example includes a substrate 7a and an encapsulation layer 7i, and a plurality of functional elements are provided between the substrate 1 and the encapsulation layer 7i. In order to avoid view interference, only functional elements 7f and 7h are shown in this figure, while the rest of the functional elements are omitted. The functional element 7f and the functional element 7h may be electrically connected via the wire as described in any of the above-mentioned examples. In Fig. 10a, the functional element 7f and the functional element 7h are connected by a wire 7g with a hollow region.

In a preferred embodiment, the substrate 7a is provided thereon with posts 7b, which are spaced from each other and arranged in a matrix.

The wire is of a film-like layer structure, that is, a wire layer is bonded and fixed on the substrate 7a, a part of the wire layer is a complete region 7d, and another part of the wire layer is a wire region which is provided with the hollow region and is taken as the wire, such as a wire 7c and a wire 7g. The complete region 7d is disposed on the respective post, the wires and the functional elements are raised relative to the substrate 7a by the posts, and a void space for accommodating the deformed wire is provided between the substrate 7a and the encapsulation layer 7i, which ensures that the functional elements and wires are not squeezed after encapsulated and allows the changes of the wires in a thickness direction after deformation.

The functional element is located on the respective complete region. In order to facilitate the stretching, the wire is arranged between two adjacent functional elements in the same row or in the same column, while there is no wire arranged between the two diagonally adjacent functional elements, such that the wire layer has a spacing region 7e between two diagonally adjacent functional elements.

If the spacing region 7e does not exist, the extension of the wire will be limited. Thus, it is further preferred that, some of the hollow regions of the wire 7g extend to two opposite sides of the wire 7g and are communicated with the spacing regions 7e at the respective sides of the wire 7g.

In other embodiments, the posts 7b may also be randomly distributed. As shown in Fig. 10b where only the substrate 7a and the posts 7b distributed on the substrate 7a are shown for the convenience of description, areas of different posts 7b may be identical or different, and the distance between the posts is not strictly limited, which may be or may not be equal.

The substrate 7a of the extendable electronic device of this example may be a polyimide (PI) substrate, a PDMS substrate or an ecoflex substrate, *etc.* The functional element may be at least one of a resistor, a capacitor, an inductor, an electrode, a Bluetooth element and a sensor element.

The encapsulation layer 7i may be provided with a cavity structure at a side facing the substrate 7a to avoid the functional elements in space. The encapsulation layer 7i may be made of a material the same as or different from that of the substrate 7a, for example, the encapsulation layer 7i may be made of a UV photocurable adhesive, a polyvinyl butyral (PVB) film, a polyvinyl chloride (PVC) film, a polyethylene terephthalate (PET) film, a polyethylene vinylacetate (EVA) film or an ethylene-tetrafluoroethylene (ETFE) copolymer film.

The wire layer is a film like paper-cut, and may be formed by coating. Alternatively, the film may be prepared first, and then the hollow region is formed by a crease manner. The crease manner may specifically be laser cutting or etching. For example, laser cutting may be directly applied to an original film to generate the hollow region, or the hollow region may be formed by etching the film at a specific position using a mask. In this example, the wire layer has a length in a range of 100 µm to 10 mm, a width in a range of 100 µm to 10 mm, and a thickness in a range of 0.3 µm to 30 µm. The hollow region has a width in a range of 0.1 µm to 10 µm. The above data are only used as an example, and may be adjusted as needed in practical application.

The wire region in the wire layer includes a conductive layer, which may be bared or may be subjected to the insulating treatment as needed, that is, an insulating layer is formed outside the conductive layer.

In the complete region of the wire layer, an upper surface of the conductive layer is bared, which is convenient for electrically connecting with the functional elements.

The conductive layer may be purely made of a conductive material, such as copper, gold, silver, *etc.,* or may be made of a composite including the conductive material and a polymer, such as PI/copper, PI/gold, EVA/copper, *etc.*

By using a large area of conductive film, the functional components of the flexible electronic device are connected by the wire, so that the functional density of the flexible electronic device is greatly improved. Moreover, by introducing the hollow region in the wire, the wire gradually extends into the strip shape during stretching the device, so that the extension rate of the device is increased, and much greater than that achieved by the traditional wave structure method, the straight wire island-bridge structure method and the serpentine wire island bridge structure method.

### Example 7

This example illustrates a method of producing a wire for use in an extendable electronic device, which specifically includes preparing a silver film on a glass slide by evaporation, and laser cutting the silver film to generate a hollow structure. The specific forms of the hollow structure may refer to the related descriptions in the above examples. In this example, bared wires are adopted, that is, once the hollow region is formed, the preparation of the wires as described in the above examples may be regarded as completed.

### Example 8

This example illustrates a method of producing a wire for use in an extendable electronic device, which specifically includes the followings.
a. A copper film is prepared by magnetron sputtering or thermal evaporation.
b. A hollow region is formed by photoetching the copper film in a wire region. The specific forms of the hollow region may refer to the related descriptions in the above examples.

### Example 9

This example illustrates a method of producing an extendable electronic device. The extendable electronic device for example is an extendable lithium ion battery.

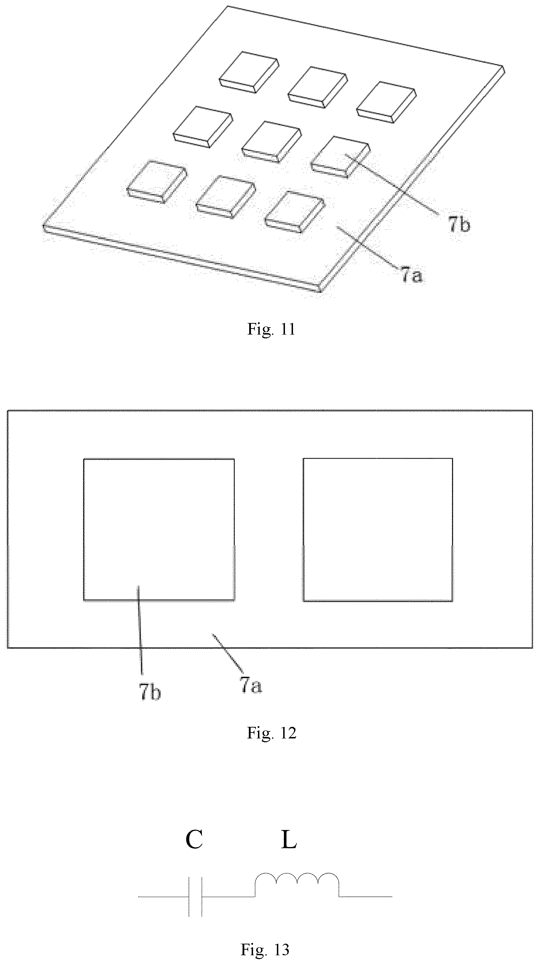

The method specifically includes the followings:
a. A first PI film (as a first insulating layer) is prepared on a glass slide by rotary casting.
b. A copper film is prepared on the surface of the first PI film by electron beam deposition, and a hollow region is generated by photoetching the copper film in a wire region. The specific forms of the hollow region may refer to the related descriptions in the above example.
c. A second PI film (as a second insulating layer) is prepared on the copper film by rotary casting, and then is etched into the same shape as the copper film by photoetching and oxygen plasma etching.
d. For a complete region, a part of one of the first and second PI films is etched away by photoetching and oxygen plasma etching to expose the copper film so as to be electrically connected with the functional elements. At this point, the preparation of the wire or the wire layer as described in above examples may be regarded as completed.
e. A PDMS substrate with posts is prepared in a mold by spin coating. The structure of the PDMS substrate with posts is as shown in Fig. 11, i.e., the substrate 7a is provided with the posts 7b. This step may also be implemented in advance, and has no strict sequence requirement in relative to the preparation of the wire.
f. The post of the substrate is subjected to ultraviolet lights to generate an active surface layer, and the wire layer obtained in step d is transferred to the substrate (in this step, it is also possible to transfer the wire prepared in Example 7 or 8 to the substrate) via transfer printing technology, and the PI film in the complete region of the wire layer is in contact with the post to form a strong adhesion.
g. A negative electrode of the lithium ion battery is bonded with the exposed copper film in the complete region by a conductive silver adhesive, and a battery array is connected in parallel.
h. Steps a to d are repeated to prepare another conductive layer, which is then transferred to the substrate (in this step, it is also possible to transfer the wire prepared in Example 7 or 8 to the substrate) via transfer printing technology, and the exposed copper film in the complete region is in contact with a positive electrode of the battery and is bonded with the positive electrode by a conductive silver adhesive, and the battery array is connected in parallel.
i. The positive and negative electrodes of the battery array are led out via wires, respectively, and then encapsulation is performed to form the stretchable lithium ion battery.

The analysis result shows that: the extendable lithium ion battery of this example may be applied to flexible sensors and wearable health monitoring equipment. When adopting the hollow structure shown in Fig. 4a, the overall extension rate of the lithium ion battery reaches 60%. When using the hollow structure shown in Fig. 8 or Fig. 9, the extension rates of the lithium ion battery are 65% and 71%, respectively. The functional density of all the designs is greater than 80%, which greatly improves the utilization of the functional elements of the device.

### Example 10

This example illustrates a method of producing an extendable electronic device. The extendable electronic device for example is s an extendable LC resonator.

The method specifically includes the followings:
a. A first PI film (as a first insulating layer) is prepared on a glass slide by rotary casting.
b. A silver film is prepared on the surface of the first PI film by evaporation, and a hollow region is generated by laser cutting the silver film. The specific forms of the hollow region may refer to the related descriptions in the above example.
c. A second PI film (as a second insulating layer) is prepared on the silver film by hot pressing, and then is etched into the same shape as the silver film by photoetching and oxygen plasma etching.
d. For a complete region, a part of one of the first and second PI films is etched away by photoetching and oxygen plasma etching to expose the silver film so as to be electrically connected with the functional elements. At this point, the preparation of the wire or the wire layer as described in above examples may be regarded as completed.
e. A PDMS substrate with a post is prepared in a mold by spin coating. The structure of the PDMS substrate is as shown in Fig. 12, i.e., the substrate 7a is provided with the posts 7b. This step may also be implemented in advance, and has no strict sequence requirement in relative to the preparation of the wire.
f. The wire layer obtained in step d is transferred to the substrate (in this step, it is also possible to transfer the wire prepared in Example 7 or 8 to the substrate) via transfer printing technology, and the PI film in the complete region of the wire layer is in contact with the post and is bonded with the post by an adhesion.
g. A capacitor and an inductor are bonded with the exposed silver film in the complete region of the wire layer by a conductive silver adhesive and are led out via wires, respectively, and then encapsulation is performed to form the serial LC circuit. The schematic diagram of the circuit is shown in Fig. 13.

The analysis result shows that: the LC circuit is able to generate signals with a specific frequency, and is a key component of the radio equipment. When the semicircular hollow structure shown in Fig. 6 is adopted, the extension rate of the LC circuit reaches 70%, and the functional density of the LC circuit reaches 90%, so that the LC circuit can play an important role in wearable wireless communication devices.

It will be understood that, in order to make the description concise, only some explanatory examples are described herein, rather than all the possible combinations of the various technical features in the above-mentioned examples. However, it will be appreciated that various technical features of the above-mentioned examples can be combined arbitrarily, as long as they are not contradictory, which also should be considered as the scope of the present disclosure.

The explanatory examples described in detail above only express several embodiments of the present disclosure, which cannot be construed as a limitation to the scope of the present disclosure. It would be appreciated by those skilled in the art that several changes and improvements can be made without departing from the spirit of the present disclosure, which all belong to the protection scope of the present disclosure, and the protection scope of the present disclosure should be subject to the appended claims.

## Claims

1. A wire for use in an extendable electronic device, wherein the wire is provided with a hollow region allowing extension and deformation of the wire.

2. The wire of claim 1, wherein the wire has a planar structure before the extendable electronic device is deformed.

3. The wire of claim 1, wherein the hollow region has at least two hollow structures spaced apart from each other, and an inner edge of at least one of the hollow regions is closed.

4. The wire of claim 1, wherein the hollow region has a smooth inner edge.

5. The wire of claim 1, wherein the wire comprises a conductive layer and an insulating layer wrapping around the conductive layer.

6. The wire of claim 1, wherein the hollow region is stripe-shaped.

7. The wire of claim 6, wherein a width of the hollow region is in a range of 0.1 µm to 10 µm.

8. The wire of claim 6, wherein the hollow region extends along a straight line or a curve.

9. The wire of claim 6, wherein different hollow regions extend in an identical way or in different ways.

10. The wire of claim 1, wherein at least two of the hollow regions are substantially half-enclosed with each other.

11. The wire of claim 1, wherein one of the hollow regions is arranged adjacent to another hollow region, and two adjacent hollow regions are substantially half-enclosed with each other.

12. The wire of claim 1, wherein at least one of the hollow regions extends to and is open at an edge of the wire.

13. The wire of claim 10, wherein projections in any direction of the two hollow regions substantially half-enclosed with each other have an overlapping area.

14. The wire of claim 5, wherein the wire has at least one deformable extension direction, and electrode connection portions for connecting with a functional element are provided at both ends of the wire in the extension direction and exposed outside the insulating layer.

15. The wire of claim 14, wherein the wire and the electrode connection portions are integral.

16. The wire of claim 1, wherein a plurality of groups of the hollow regions are arranged in an extension direction to divide the wire into a plurality of ring structures arranged in sequence, and adjacent ones of the ring structures are connected via a transition portion.

17. The wire of claim 16, wherein the hollow region is stripe-shaped and extends in a direction perpendicular or oblique to the extension direction, and the hollow region between the adjacent ones of the ring structures extends to and opens at a respective edge of the wire.

18. The wire of claim 1, wherein one or more groups of the hollow regions are arranged in an extension direction, the same group of the hollow regions comprises two units in the extension direction, one or more of the hollow regions in the same unit are arranged in a direction perpendicular or oblique to the extension direction, and adjacent ones of the hollow regions in the same group but in different units are substantially half-enclosed with each other.

19. The wire of claim 1, wherein the hollow region is formed by coating, etching or cutting.

20. A method of producing a wire for use in an extendable electronic device, comprising:
forming a conductive layer and processing a respective region of the conductive layer to obtain a hollow region.

21. The method of claim 20, wherein the wire is a wire according to any one of claims 1 to 19.

22. A method of producing a wire for use in an extendable electronic device, comprising:
preparing a first insulating layer;
forming a conductive layer on the first insulating layer, and processing a respective region of the conductive layer to obtain a hollow region;
preparing a second insulating layer, and wrapping the conductive layer by the first insulating layer and the second insulating layer.

23. The method of claim 22, wherein the wire is a wire according to any one of claims 1 to 19.

24. An extendable electronic device, comprising a substrate and an encapsulation layer, wherein a plurality of functional elements are arranged between the substrate and the encapsulation layer, and at least two of the functional elements are electrically connected with each other via a wire according to any one of claims 1 to 19.

25. The extendable electronic device of claim 24, wherein a wire layer is bonded and fixed on the substrate, a part of the wire layer is a complete region where the functional element is located, and another part of the wire layer is provided with the hollow region and is taken as the wire.

26. The extendable electronic device of claim 25, wherein a post is provided on the substrate, the complete region is disposed on the post, and a void space for accommodating the deformed wire is provided between the substrate and the encapsulation layer.

27. The extendable electronic device of claim 26, wherein the posts are spaced from each other.

28. The extendable electronic device of claim 27, wherein a spacing region is disposed between the posts, and at least one of the hollow regions of the wire extends to an edge of the wire and opens to a spacing region adjacent to the edge of the wire.

29. A method of producing an extendable electronic device according to any one of claims 24 to 28, comprising providing a substrate and forming at least one wire layer and at least one functional element layer on the substrate, followed by encapsulating;
wherein the wire layer and the functional element layer are formed on the substrate layer by layer, or the functional element layer is formed on the wire layer in advance.
